# EUROPEAN PATENT APPLICATION

(11) **EP 4 726 473 A1**
(43) Date of publication of application: **15.04.2026**
(21) Application number: 24206217.2
(22) Date of filing: 11.10.2024
(51) Int. Cl.: G03F 7/00

(54) **HUMIDIFICATION OF LOW GAS FLOWS**

(71) Applicant: ASML Netherlands B.V., 5500 AH Veldhoven (NL)
(72) Inventor: TIJSSEN, Edwin, Petrus, Alois, Maria,, 5500AH Veldhoven (NL); LIN, Yu-Ting, 5500AH Veldhoven (NL); VAN DUUREN, Joris, Egidius, Pieter, 5500AH Veldhoven (NL); JANSSEN, Franciscus, Johannes, Joseph, 5500AH Veldhoven (NL)
(74) Representative: ASML Netherlands B.V.

(57) **Abstract**

A humidifier device for generating a purge gas for a lithographic apparatus, the device comprising: a first gas inlet configured to receive a first flow of a first gas; a second gas inlet configured to receive a second flow of the first gas; an enricher configured to generate an enriched gas flow comprising the second flow of the first gas and water or hydrogen peroxide; and a mixer configured to mix the first flow of the first gas with an enriched gas derived from the enriched gas flow to generate the purge gas.

## Description

### FIELD

The present invention relates to a humidifier device and a method for use in combination with a lithographic apparatus and a method for manufacturing a device.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus may use an EUV radiation source. Once the EUV radiation has been generated, it is directed through the lithographic apparatus by a plurality of optical components, such as mirrors, to a patterning surface of the patterning device, which imparts the desired pattern to the EUV radiation. Other components, such as sensors and detectors, may also be present in the lithographic apparatus. Surface degradation of the optical components can undesirably impair the properties of these components, for example reducing the reflectivity of the mirrors for the EUV radiation, thus reducing the transmission of EUV radiation. Surface degradation of other components can undesirably damage these components, for example reducing the performance and/or the operational efficiency of the component. Thus, surface degradation of certain components of the lithographic apparatus should be avoided or mitigated.

Surface degradation may be caused by, for example, the chemical reaction of ions or contaminants with the component surface. Gas purging might be used to prevent or mitigate surface degradation of components.

One method of mitigating the reduced transmission of EUV radiation involves purging, for example, an oxygen-containing gas in the lithographic apparatus. However, introducing too much oxygen to the lithographic apparatus may risk damaging one or more optical components of the lithographic apparatus, e.g. mirrors configured to reflect the EUV radiation beam. The amount of oxygen to be introduced to the lithographic apparatus may be relatively small. The balance between providing too much oxygen and too little oxygen may be delicate and require accurate and reliable control. It is desirable to provide a device and method of accurately and reliably controlling the relatively small amount of oxygen or humidity in the purge gas that is to be provided to the lithographic apparatus.

Known devices and methods of providing a controlled amount of gas may be unsuitable for providing the relatively small amounts of oxygen required in a lithographic apparatus and/or for maintaining a reliably accurate and precise amount of gas within the lithographic apparatus. For example, known mass flow controllers may provide a minimum amount of oxygen within the purge gas that is between about 100 and about 1000 times greater than the amount of oxygen required in the EUV lithographic apparatus. That is, known mass flow controller may introduce too much oxygen to the lithographic apparatus and damage components, such as optical components, of the lithographic apparatus. Furthermore, known mass flow controllers may not offer adequate accuracy in maintaining a steady flow of the relatively small amount of oxygen.

Thus, it is a challenge to control the amount of humidity (and thus oxygen) in the gas purged into the vacuum environment, which typically operates at pressures below 20 Pa and requires controlled, low gas flows. It may be desirable to provide a new lithographic system, and associated methods for operation, that at least partially addresses one or more problems associated with prior art arrangements, whether identified herein or otherwise.

### SUMMARY

An aim of the present invention is to provide a humidifier device and method that generates a purge gas with controlled amount of humidity for a lithographic apparatus.

According to an aspect of the invention there is provided a humidifier device for generating a purge gas for a lithographic apparatus, the device comprising:
a first gas inlet configured to receive a first flow of a first gas; a second gas inlet configured to receive a second flow of the first gas; an enricher configured to generate an enriched gas flow comprising the second flow of the first gas and water or hydrogen peroxide; and a mixer configured to mix the first flow of the first gas with an enriched gas derived from the enriched gas flow to generate the purge gas.

According to another aspect of the present invention, there is provided a method for generating a purge gas in a lithographic apparatus, the method comprising:
receiving a first flow of a first gas through a first gas inlet; receiving a second flow of the first gas through a second gas inlet; generating an enriched gas flow comprising the second flow of the first gas and water or hydrogen peroxide; and mixing the first flow of the first gas with an enriched gas derived from the enriched gas flow to generate the purge gas.

### BRIEF DESCRIPTION OF THE DRAWINGS

Embodiments of the invention will now be described, by way of example only, with reference to the accompanying schematic drawings, in which:
Figure 1 is a schematic illustration of a lithographic system comprising a lithographic apparatus and a radiation source;
Figure 2 is a schematic illustration of a humidifier device for generating a purge gas for a lithographic apparatus.
Figure 3 is a schematic illustration of a humidifier device for generating a purge gas for a lithographic apparatus, with possible additional embodiments.
Figures 4A and 4B are schematic illustrations of an alternative humidifier device for generating a purge gas for a lithographic apparatus.
Figure 5 is a schematic illustration of another alternative humidifier device for generating a purge gas for a lithographic apparatus.
Figure 6 depicts a flowchart of the method according to the invention.

### DETAILED DESCRIPTION

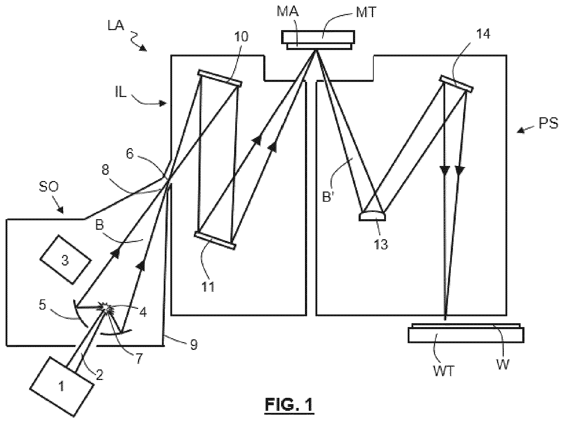

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The dose of radiation that is provided to the substrate W is an important consideration when performing a lithographic exposure. The dose of radiation reaching the substrate W may vary over time due to unwanted absorption of EUV radiation. For example, surfaces within the lithographic apparatus may release one or more chemicals (e.g. silanes) into an internal environment of the lithographic apparatus. The presence of said chemicals may reduce a transmission of EUV radiation through the internal environment of the lithographic apparatus, thus reducing the dose of radiation provided to the substrate. In order to mitigate the reduced transmission of EUV radiation, a purge gas may be introduced to the lithographic apparatus. The purge gas may comprise oxygen, for instance in the form of water vapor or hydrogen peroxide vapor, since water molecules and hydrogen peroxide molecules contain oxygen atoms. The lithographic apparatus may, for example, be an extreme ultraviolet (EUV) lithographic apparatus. The present invention relates to a system for providing a controlled amount of humidity in the purge gas to an apparatus such as a lithographic apparatus.

One method of accurately controlling the relatively small amount of oxygen that is to be provided to the lithographic apparatus includes mixing a gas with an enriched gas comprising water vapor, before introducing a controlled flow of the mixture of gases, also called a purge gas, to the lithographic apparatus. The purge gas may comprise a suitably low concentration of water, and thus oxygen atoms, that is suitable for use in a lithographic apparatus. For example, hydrogen gas may be mixed with a water enriched hydrogen gas, in order to dilute the amount of water vapor to a lower concentration, so that the amount of water, and thus oxygen atoms, provided in the purge gas is controlled. For example, helium gas and/or clean dry air (CDA) and/or extreme clean dry air (XCDA) may be mixed with a water enriched hydrogen gas, in order to dilute the amount of water vapor to a lower concentration, so that the amount of water, and thus oxygen atoms, provided in the purge gas is controlled.

In a similar method as described above, hydrogen peroxide vapor may be used instead of water vapor, to provide a purge gas that comprises a low concentration of hydrogen peroxide, and thus oxygen atoms.

For example, if hydrogen gas is to be used with oxygen, the mixing of hydrogen gas with oxygen gas is extremely hazardous. Thus, a humidifier device provides a good alternative to enable mixing hydrogen gas with oxygen atoms in a safe way. Also, there is a narrow pressure budget to humidify hydrogen gas, as the incoming pressure is limited by hydrogen gas safety rules and downstream components require a minimum outgoing pressure. Normally, if the humidity level is changed, the flow is also changed and therefore the pressure changes as well. This invention relates to a humidifier device in which the humidity level of the gas may be changed while the total gas flow may be kept constant - and thus the pressure may remain constant as well.

The purge gas may be distributed amongst one or more desired locations within the lithographic apparatus. The desired locations within the lithographic apparatus may receive equal, different, or varying portions of the purge gas. The purge gas may be introduced to the lithographic apparatus using flow controllers, such as mass flow controllers or volume flow controllers, since the concentration of oxygen atoms in the purge gas is suitably low. That is, the mixing of gases enables the provision of low partial pressures of water and/or hydrogen peroxide, and thus oxygen atoms, proximate the components of the lithographic apparatus with suitable accuracy and stability. Such components of the lithographic apparatus may be optical components, such as mirrors, or other components of the lithographic apparatus, such as sensors. For example, any surface of a component of the lithographic apparatus that contains silicon may react with hydrogen radicals, and these surfaces may benefit from low oxygen flow. Use of purging gases containing hydrogen and/or helium are preferred when EUV light is used. Use of purging gases containing CDA or XCDA are preferred when EUV light is not used in the lithographic apparatus.

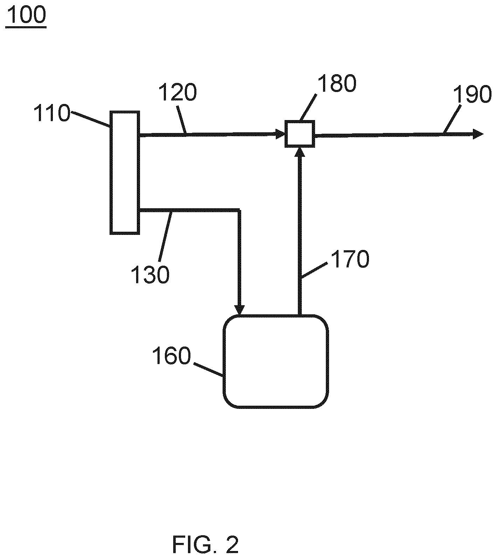

A humidifier device 100 for providing a purge gas 190 to a lithographic apparatus is described in Figure 2. A gas source 110 provides a first flow 120 of a first gas, such as hydrogen gas and/or helium gas, and a second flow 130 of the first gas. The second flow 130 of the first gas passes through an enricher 160 configured to generate an enriched gas flow 170 comprising the second gas flow 130 of the first gas and water and/or hydrogen peroxide. The enricher may be, for instance, a cartridge containing liquid water and a partial pressure of water vapor, and/or liquid hydrogen peroxide and a partial pressure of hydrogen peroxide. A mixer 180 is configured to mix the first flow 120 of the first gas with an enriched gas derived from the enriched gas flow 170 to generate a purge gas 190. The purge gas 190 has a low concentration of water vapor and/or hydrogen peroxide, and thus a low concentration of oxygen atoms. Therefore the humidifier device 100 is able to provide a controlled amount of water vapor and/or hydrogen peroxide in the purge gas 190.

Additives may be added to the water or hydrogen peroxide in the enricher. The additives may be used to control the evaporation of the water in the enricher, or used as an additional source of oxygen atoms. Additives may be, for example, oxygen-containing mixtures such as peroxides.

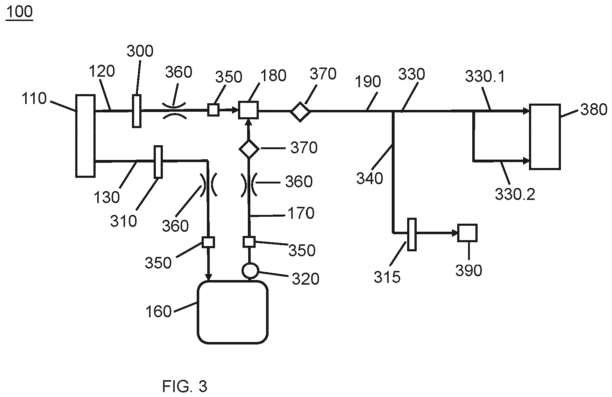

A humidifier device 100 for generating a purge gas 190 for a lithographic apparatus, with possible additional embodiments, is shown in Figure 3. A flow controller 300 may be used to control the first flow 120 of the first gas, and/or another flow controller 310 may be used to control the second flow 130 of the first gas. The flow controller may be, for example, a mass flow controller or a volume flow controller. A valve 350 may be used to open or close the first flow 120 of the first gas, and/or to open or close the second flow 130 of the first gas. Additionally, a flow constrictor 360 may be used to constrict the first flow 120 of the first gas, and/or to constrict the second flow 130 of the first gas, such that the gas flows in one direction and back flow is avoided. Also, a valve 350 and/or a flow constrictor 360 may also be used to, respectively, open or close the enriched gas flow and avoid back flow of the enriched gas.

A pressure sensor and/or pressure controller 320 may be provided to monitor and/or control a pressure of the enriched gas. Examples of pressure sensors that could be provided in the current invention are Pirani manometer, Penning manometer, Piezo gauge and/or capacitance diaphragm gauge. Additionally, a humidity sensor may be used, such as a chilled-mirror sensor, and/or a capacitance dew point sensor. Figure 3 shows a humidity sensor 370 used to measure the humidity level of the enriched gas. Alternatively, a humidity sensor 370 may be used to measure the humidity level of the purge gas. Depending on the pressure and/or humidity level of the enriched gas and/or the purge gas, the first flow 120 of the first gas, and the second flow 130 of the first gas may be adjusted in order to achieve the desired level of humidity in the purge gas. Also, a temperature sensor, such as a thermocouple and/or a Pt100, may be used to measure the temperature of the enriched gas and/or the purge gas.

The purge gas 190 may be split between separate branches 330 and 340. Branch 330 may also be referred to as a first outlet, and is configured to output a first amount of the purge gas to an interior 380 of the lithographic apparatus. Branch 340 may also be referred to as a second outlet, and is configured to output a second amount of the purge gas to a dump 390, exterior to the lithographic apparatus. The dump 390 is configured to receive any excess purge gas that is not needed in an interior 380 of the lithographic apparatus.

Branch 330 may be further split between separate branches 330.1 and 330.2, in order to supply portions of the purge gas to different parts of the interior of the lithographic apparatus. Branches 330.1 and 330.2 are configured to supply a controlled amount of the purge gas 190 having a low concentration of oxygen atoms to different parts of the interior of the lithographic apparatus. For example, a first portion of the first amount of the purge gas may be supplied to a projection system, and/or a second portion of the first amount of the purge gas may be supplied to an illumination system of the lithographic apparatus. Each branch may have a flow controller 315, such a mass flow controller, to control the purge gas flow on that branch. For instance, a flow controller may be present in branch 340, and/or branch 330 or branch 330.1 and/or branch 330.2. A valve 350 and/or a flow constrictor 360 may also be used to, respectively, open or close the purge gas flow and avoid back flow of the purge gas 190 in each of the branches 330, 330.1, 330.2 and 340.

A larger or smaller number of branches may be used. Alternative or additional branches may e.g. be applied to provide a flow of the purge gas 190 to one or more mirrors of the illumination and/or projection system. The purge gas 190 may be provided to any desired part of the lithographic apparatus. For example, a portion of purge gas may be provided to an area of the lithographic apparatus in use comprising a reticle and/or a substrate.

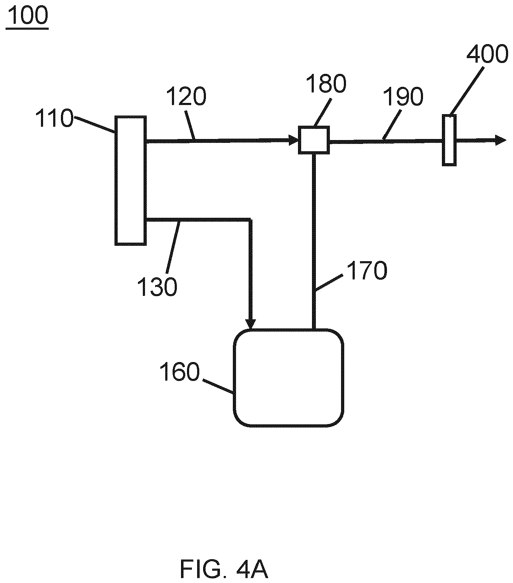

Alternatively, the humidifier device may have a flow controller 400, such a mass flow controller, only after the purge gas 190 is generated. This embodiment is preferred when the pressure of the first gas flow is very low, for example due to safety regulations in the case of pure hydrogen gas being used. This configuration would minimize the pressure drop by using only one mass flow controller in the invention, although still being able to deliver a controlled flow and humidity level of the purge gas. Figure 4A shows a schematic illustration of a humidifier device built in such configuration.

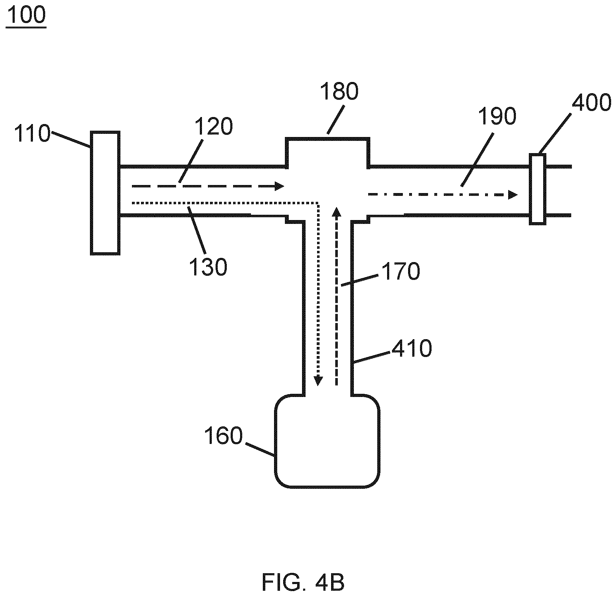

The second flow 130 of the first gas and the enriched gas flow 170 may be combined in one flow channel. This embodiment is schematically shown in Figure 4B. In Figure 4B, a gas source 110 provides a first flow 120 of a first gas, such as hydrogen gas and/or helium gas, and a second flow 130 of the first gas. The first flow 120 of the first gas and the second flow 130 of the first gas may share the same flow channel, and/or the second flow of the first gas may originate from the first flow 120 of the first gas. The second flow 130 of the first gas passes through an enricher 160 configured to generate an enriched gas flow 170 comprising the second gas flow 130 of the first gas and water and/or hydrogen peroxide. The enricher may be, for instance, a cartridge containing liquid water and a partial pressure of water vapor, and/or liquid hydrogen peroxide and a partial pressure of hydrogen peroxide. The second flow 130 of the first gas and the enriched gas flow 170 may be combined in one flow channel 410. A mixer 180 is configured to mix the first flow 120 of the first gas with an enriched gas derived from the enriched gas flow 170 to generate a purge gas 190. Similarly to the embodiment described in 4A, the humidifier device 100 may have a flow controller 400, such a mass flow controller, only after the purge gas 190 is generated.

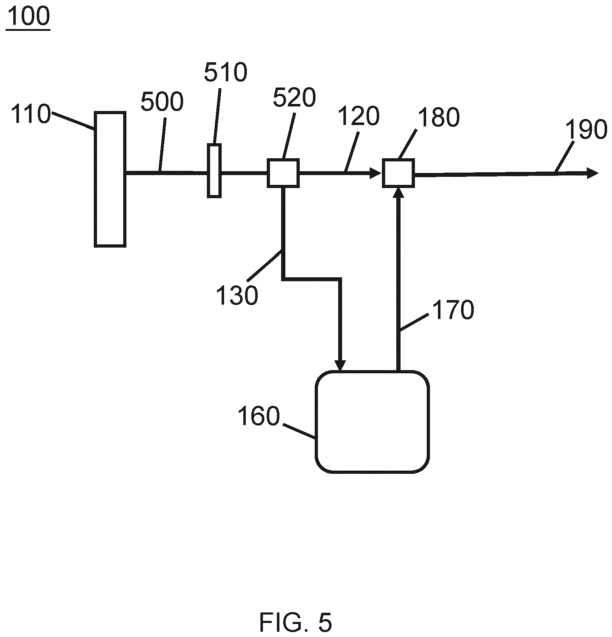

Figure 5 shows a schematic illustration of another alternative humidifier device for generating a purge gas for a lithographic apparatus. In a different embodiment, a gas source 110 provides a flow of a first gas 500. The flow of the first gas 500 may be controlled with a flow controller 510, and then a three-way valve 520 may be used to split the flow of the first gas 500 into a first flow of the first gas 120 and a second flow of the first gas 130. This three-way valve is actuated to control the flow balance between the first flow of the first gas and the second flow of the first gas. The second flow of the first gas 130 passes through an enricher 160 configured to generate an enriched gas flow 170 comprising the second gas flow 130 of the first gas and water or hydrogen peroxide. The enricher may be, for instance, a cartridge containing liquid water and a partial pressure of water vapor. The enricher may be, for instance, a cartridge containing liquid hydrogen peroxide and a partial pressure of hydrogen peroxide vapor. A mixer 180 is configured to mix the first flow 120 of the first gas with an enriched gas derived from the enriched gas flow 170 to generate a purge gas 190. The purge gas 190 has a low concentration of water vapor or hydrogen peroxide vapor, and thus a low concentration of oxygen atoms. Therefore the humidifier device 100 is able to provide a controlled amount of water vapor or hydrogen peroxide in the purge gas 190.

The humidifier device for generating a purge gas for a lithographic apparatus may have a flow rate such that the nominal H2O content in the purge gas is between 0.0030 sccm and 0.2000 sccm, or between 0.0080 sccm and 0.1000 sccm, or preferably between 0.0130 sccm and 0.0500 sccm.

For example, the humidity level of the purge gas may be achieved by the cooperation of mass flow controllers, humidity sensor and pressure sensor. From the humidity sensor we get the reading of water vapor pressure, for example a nominal value of 250 Pa. This value may be divided by the total pressure, for example a nominal value of 50000 Pa, in order to provide the humidity level of the purge gas. A mass flow controller controls the total hydrogen flow, for example 10 sccm of flowrate. Thus the total water content of the purge gas can be obtained by 10 x (250/50000) = 0.05 sccm.

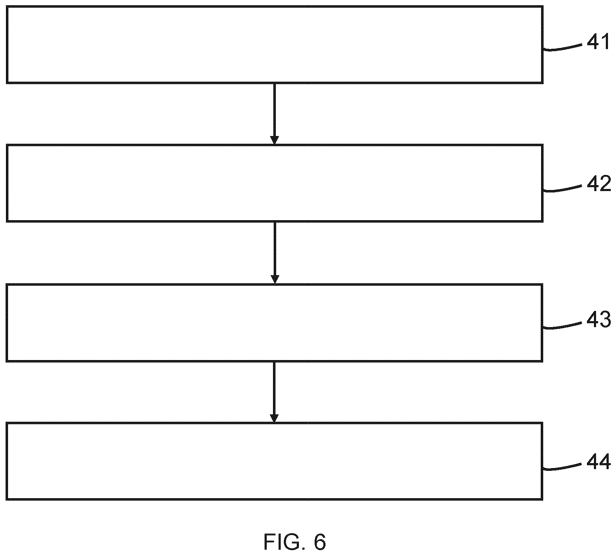

A flowchart of the method according to the invention is shown in Figure 6. Figure 6 shows a method for generating a purge gas in a lithographic apparatus, the method comprising: receiving a first flow of a first gas through a first gas inlet (41); receiving a second flow of the first gas through a second gas inlet (42); generating an enriched gas flow comprising the second flow of the first gas and water or hydrogen peroxide (43); and mixing the first flow of the first gas with an enriched gas derived from the enriched gas flow to generate the purge gas (44).

An additional feedback loop may be used to control the mixing ratio of the first flow of the first gas and the enriched gas flow, so that a desired humidity level is reached in the purge gas. The feedback loop may receive input signal from at least one of the sensors - such as a temperature sensor, and/or a pressure sensor, and/or a humidity sensor - for precise measurement. Based on such measurement, one or more gas flows may then be adjusted in order to generate a purge gas with a desired level of humidity.

The humidifier device of the current invention works in under pressure range (below 1 atm, for example 0.2-0.8 atm range). The humidifier device may also work when a very low flow of the first gas is used, for example between 3-20 sccm range.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A humidifier device for generating a purge gas for a lithographic apparatus, the device comprising:
a first gas inlet configured to receive a first flow of a first gas;
a second gas inlet configured to receive a second flow of the first gas;
an enricher configured to generate an enriched gas flow comprising the second flow of the first gas and water or hydrogen peroxide; and
a mixer configured to mix the first flow of the first gas with an enriched gas derived from the enriched gas flow to generate the purge gas.

2. The humidifier device of claim 1, wherein the first gas comprises hydrogen gas, and/or helium gas, and/or clean dry air (CDA), and/or extreme clean dry air (XCDA).

3. The humidifier device of any preceding claim, wherein the humidifier device is configured to control the first flow of the first gas and/or the second flow of the first gas and/or the flow of the purge gas.

4. The humidifier device of claim 3, wherein the humidifier device comprises a mass flow controller, and/or a volume flow controller for controlling the first gas flow and/or the second gas flow.

5. The humidifier device of any preceding claim, wherein a flow constrictor is used to constrict the first flow of the first gas, and/or the second flow of the first gas, and/or the enriched gas flow.

6. The humidifier device of any preceding claim, wherein a nominal H2O content in the purge gas is between 0.0030 sccm and 0.2000 sccm, or between 0.0080 sccm and 0.1000 sccm, or between 0.0130 sccm and 0.0500 sccm.

7. The humidifier device from any preceding claim, further comprising:
a first outlet configured to output a first amount of the purge gas to an interior of the lithographic apparatus; and
a second outlet configured to output a second amount of the purge gas to a dump, exterior to the lithographic apparatus.

8. The humidifier device according to claim 7, wherein the first outlet comprises an outlet flow controller for controlling the first amount of the purge gas.

9. The humidifier device according to claim 7, wherein the first outlet comprises a first outlet flow controller for controlling a first portion of the first amount of the purge gas and a second outlet flow controller for controlling a second portion of the first amount of the purge gas.

10. The humidifier device according to any of claims 7-9, wherein the second outlet comprises an outlet flow controller for controlling the second amount of the purge gas.

11. The humidifier device according to any of the preceding claims, further comprising a pressure sensor and/or pressure controller for controlling a pressure of the purge gas.

12. The humidifier device according to any of the preceding claims, further comprising a humidity sensor for sensing the amount if H2O of the enriched gas and/or the purge gas.

13. The humidifier device according to any of claims 7-12, wherein the humidifier device is configured to supply the first portion of the first amount of the purge gas to a projection system and/or the second portion of the first amount of the purge gas to an illumination system of the lithographic apparatus.

14. The humidifier device according to claim 13, wherein the humidifier device is configured to supply a third portion of the first amount of the purge gas to an area of the lithographic apparatus in use comprising a reticle and/or a substrate.

15. An EUV lithographic apparatus comprising a humidifier device according to any of the preceding claims.

16. The EUV lithographic apparatus according to claim 15, further comprising a vacuum compartment.

17. A method for generating a purge gas in a lithographic apparatus, the method comprising:
receiving a first flow of a first gas through a first gas inlet;
receiving a second flow of the first gas through a second gas inlet;
generating an enriched gas flow comprising the second flow of the first gas and water or hydrogen peroxide; and
mixing the first flow of the first gas with an enriched gas derived from the enriched gas flow to generate the purge gas.

18. The method of claim 17, wherein the first gas comprises hydrogen gas, and/or helium gas, and/or clean dry air (CDA), and/or extreme clean dry air (XCDA).

19. The method of claim 17 or 18, further comprising controlling the first flow of the first gas and/or the second flow of the first gas and/or the flow of the purge gas.

20. The method of any of claims 17-19, wherein a flow constrictor is used for constricting the first flow of the first gas, and/or the second flow of the first gas, and/or the enriched gas flow.

21. The method of any of claims 17-20, wherein the purge gas contains a nominal H2O content between 0.0030 sccm and 0.2000 sccm, or between 0.0080 sccm and 0.1000 sccm, or between 0.0130 sccm and 0.0500 sccm.

22. The method of any of claims 17-21, further comprising:
outputting a first amount of the purge gas to an interior of the lithographic apparatus; and
outputting a second amount of the purge gas to a dump, exterior to the lithographic apparatus.

23. The method of claim 22, further comprising using a flow controller for controlling the first amount of the purge gas and/or the second amount of the purge gas.

24. The method of claim 22 or 23, wherein the first outlet comprises a first outlet flow controller for controlling a first portion of the first amount of the purge gas and a second outlet flow controller for controlling a second portion of the first amount of the purge gas.

25. The method of any of claims 17-24, further comprising a pressure sensor and/or pressure controller for controlling a pressure of the purge gas.

26. The method of any of claims 22-25, wherein the humidifier device is configured to supply the first portion of the first amount of the purge gas to a projection system and/or the second portion of the first amount of the purge gas to an illumination system of the lithographic apparatus.

27. The method of any of claims 17-26, wherein the method is used in an EUV lithographic apparatus.
